# FASCICULE DE BREVET EUROPEEN

(11) **EP 2 951 013 B1**
(45) Date de publication et mention de la délivrance du brevet: **08.08.2018**
(21) Numéro de dépôt: 14701577.0
(22) Date de dépôt: 29.01.2014
(51) Int. Cl.: B32B 18/00, C04B 35/571, C04B 35/573, C04B 35/80, C04B 37/00, E04C 2/36, G10K 11/172, C04B 35/83, C04B 35/111, C04B 35/48, F02K 1/82, F02C 7/045

(54) **PROCEDE DE FABRICATION D'UN PANNEAU CERAMIQUE D'ATTENUATION ACOUSTIQUE DE FORME COURBEE**
VERFAHREN ZUR HERSTELLUNG EINER KERAMISCHEN, KURVENFÖRMIGEN, SCHALLDÄMPFENDEN PLATTE
PROCESS FOR MANUFACTURING A CURVED CERAMIC SOUND-ATTENUATING PANEL

(30) Priorité: 29.01.2013 FR 1350723
(43) Date de publication de la demande: 09.12.2015
(73) Titulaire: Safran Ceramics, 33185 Le Haillan (FR)
(72) Inventeur: FOUQUET, Stéphanie, F-33160 Saint Medard en Jalles (FR); JIMENEZ, Sébastien, F-33000 Bordeaux (FR); PHILIPPE, Eric, F-33700 Merignac (FR); GOULLIANE, Eddy, F-33160 Saint Medard en Jalles (FR)
(74) Mandataire: Desormiere, Pierre-Louis
(86) Numéro de dépôt international: PCT/EP2014/051698
(87) Numéro de publication internationale: WO 2014/118216

(56) Documents cités:
- EP-A1- 0 573 353
- EP-A1- 0 611 741
- EP-A1- 0 796 829
- WO-A1-2010/061140
- US-A1- 2009 263 627

## Description

### Arrière-plan de l'invention

La présente invention se rapporte au domaine général des panneaux d'atténuation acoustiques. Elle concerne plus particulièrement les panneaux d'atténuation acoustiques utilisés pour réduire les bruits produits dans les moteurs d'avion comme dans les turbines à gaz ou échappement de ceux-ci.

Afin de réduire le bruit dans les conduits d'échappement des turbines à gaz, il est connu de doter les surfaces des éléments délimitant ces conduits de panneaux d'atténuation acoustiques. Ces panneaux sont typiquement constitués d'une paroi de surface multiperforée perméable aux ondes acoustiques que l'on souhaite atténuer et d'une paroi pleine réfléchissante, un corps cellulaire, tel qu'un nid d'abeille ou une structure poreuse, étant disposé entre ces deux parois. De façon bien connue, de tels panneaux forment des résonateurs de type Helmholtz qui permettent d'atténuer dans une certaine gamme de fréquences les ondes acoustiques produites dans le conduit.

Les éléments constitutifs de ce type de panneau (parois et corps cellulaire) sont en général réalisés en matériau métallique comme décrits dans les documents US 5 912 442 et GB 2 314 526. Cependant, dans des domaines techniques où le gain de masse est une préoccupation constante, comme en aéronautique, l'utilisation de panneaux d'atténuation acoustique en matériau métallique est relativement pénalisante.

Le document US 8 043 690 décrit un panneau d"atténuation acoustique dont les parois et le corps cellulaire sont formés à partir de matériaux composites (renfort fibreux densifié par une matrice) permettant un gain de masse par rapport aux matériaux métalliques habituellement utilisés. Cependant, ce document ne divulgue que des panneaux ou des sous-ensembles de panneaux qui présentent des formes planes, le traitement acoustique d'une pièce présentant une forme cylindrique ou tronconique étant réalisé en alignant sur la paroi de la pièce une pluralité de sous-ensembles d'atténuation acoustique de forme plane ou rectiligne. Cette technique de fabrication nécessite un nombre d'opérations important pour la constitution du panneau acoustique à partir de sous-ensembles plans qui pénalise l'optimisation et le coût de fabrication du panneau.

Le document EP 0 796 829 décrit un panneau sandwich de type nid d'abeilles en matériau composite thermostructural.

Or, il existe un besoin de disposer d'une solution permettant de fabriquer des panneaux d'atténuation acoustique en matériau composite, et en particulier en matériau composite à matrice céramique (CMC), ayant une forme courbée adaptée à la géométrie de la pièce à insonoriser.

### Objet et résumé de l'invention

A cet effet, la présente invention propose un procédé de fabrication d'un panneau d'atténuation acoustique en matériau composite à matrice céramique (CMC) de forme courbée comprenant les étapes suivantes :
- imprégnation d'une structure fibreuse définissant une structure alvéolaire avec une résine précurseur de céramique,
- polymérisation de la résine précurseur de céramique avec maintien de la structure fibreuse de la structure alvéolaire sur un outillage présentant une forme courbée correspondant à la forme finale de la structure alvéolaire,
- accostage de la structure alvéolaire avec des première et deuxième peaux de manière à fermer les cellules de ladite structure, chaque peau étant formées d'une structure fibreuse imprégnée avec une résine précurseur de céramique, chaque peau étant accostée à ladite structure alvéolaire avant ou après polymérisation de la résine desdites peaux, et avant transformation de la résine de la structure alvéolaire en céramique par pyrolyse,
- pyrolyse de l'assemblage constitué par la structure alvéolaire et les première et deuxième peaux,
- densification dudit assemblage par infiltration chimique en voie gazeuse (CVI).

Ainsi, conformément au procédé de l'invention, on réalise tout d'abord une structure alvéolaire qui est consolidée suivant la forme courbée désirée par polymérisation de la résine d'imprégnation. A ce stade, c'est-à-dire après polymérisation et avant transformation de la résine en céramique par pyrolyse, la structure alvéolaire présente une rigidité suffisante pour être autoporteuse et conserver sa mise en forme courbée tout en ayant encore une certaine souplesse ou déformabilité. De même, les peaux sont assemblées à la structure alvéolaire au stade imprégné ou polymérisé, c'est-à-dire avant pyrolyse de leur résine d'imprégnation. Il est ainsi possible de réaliser des panneaux d'atténuation acoustique en matériau CMC ayant des formes courbées correspondant précisément à la forme de la pièce dans laquelle ils sont destinés à être intégrés.

Lorsque les pièces constitutives du panneau acoustique sont assemblées au stade imprégné, elles présentent encore une souplesse ou déformabilité permettant une réduction des jeux entre les pièces à assembler et un meilleur respect des tolérances de forme vis-à-vis du panneau acoustique final à réaliser.

En outre, la structure alvéolaire consolidée joue le rôle de support de maintien et de conformation pour les peaux, ce qui permet de réaliser la pyrolyse et la densification de l'ensemble de ces éléments sans outillage de mise en forme et, par conséquent, de réduire les coûts de fabrication du panneau d'atténuation acoustique.

La densification commune (co-densification) par CVI des éléments du panneau acoustique permet de renforcer la liaison entre ces éléments.

Selon un premier aspect du procédé de l'invention, au moins une des deux peaux est accostée à la structure alvéolaire avant polymérisation de la résine d'imprégnation de la peau, le procédé comprenant une étape de polymérisation de la résine de la peau après l'étape d'accostage et avant l'étape de pyrolyse.

Selon un deuxième aspect du procédé de l'invention, une des deux peaux est placée sur un outillage comportant des aiguilles traversant ladite peau, la structure alvéolaire étant accostée avec ladite peau placée sur l'outillage de manière à réaliser des perforations dans ladite peau. On réalise ainsi simultanément, la formation de perforations dans la peau acoustique et son assemblage à la structure alvéolaire.

Selon un troisième aspect du procédé de l'invention, la résine d'au moins une des deux peaux est polymérisée avant son accostage avec la structure alvéolaire, ladite peau étant maintenue pendant la polymérisation sur un outillage présentant une forme courbée similaire à la forme courbée de la structure alvéolaire et en ce qu'une colle comprenant au moins une résine précurseur de céramique est déposée sur les parties de la structure alvéolaire destinées à être en contact avec la peau.

Selon un quatrième aspect du procédé de l'invention, la colle comprend en outre une charge solide constituée d'une poudre d'un matériau réfractaire.

Selon un cinquième aspect du procédé de l'invention, la première peau est accostée à la structure alvéolaire après polymérisation de sa résine d'imprégnation, le procédé comprenant, avant l'accostage de la deuxième peau à la structure alvéolaire, une étape de perçage de multiperforations dans la première peau, la deuxième peau étant accostée à la structure alvéolaire après ladite étape de perçage.

Selon un sixième aspect du procédé de l'invention, celui-ci comprend la réalisation d'une structure fibreuse déployable définissant une structure alvéolaire. La structure fibreuse déployable peut être notamment réalisée par tissage tridimensionnel ou tissage multicouche.

Le corps cellulaire et les peaux associées sont réalisées en matériau composite thermostructural, c'est-à-dire en matériau composite notamment carbone/carbone et matériau composite à matrice céramique. Dans le cas de la réalisation de ces éléments en matériau composite à matrice céramique, les structures fibreuses de la structure alvéolaire et des peaux peuvent être réalisées en particulier à partir de fibres de carbure de silicium tandis que la résine d'imprégnation de la structure alvéolaire et des peaux peut être une résine précurseur de carbure de silicium et en ce que l'étape de densification comprend l'infiltration chimique en voie gazeuse de carbure de silicium.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels:
- la figure 1 est une vue schématique en perspective d'un panneau d'atténuation acoustique de forme courbée conformément à un mode de réalisation de l'invention;
- la figure 2 est un ordinogramme des étapes d'un procédé de fabrication d'un panneau d'atténuation acoustique de forme courbée conformément à un mode de réalisation de l'invention;
- la figure 3 est une vue schématique en perspective d'une structure fibreuse déployable utilisée pour réaliser une structure alvéolaire;
- les figures 4A à 4C montrent la fabrication d'une structure fibreuse déployable conformément à un mode de réalisation de l'invention;
- les figures 5A à 5C montrent la fabrication d'une structure fibreuse déployable conformément à un autre mode de réalisation de l'invention;
- les figures 6A et 6B sont respectivement des vues agrandies de deux plans successifs d'une armure de tissage d'une structure fibreuse déployable conformément à un mode de réalisation de l'invention;
- les figures 7A à 7L montrent des plans d'armure permettant de réaliser une structure fibreuse du même type que la structure fibreuse des figures 6A et 6B mais dont les fils de trame et de chaîne sont orientés à 45° par rapport à l'axe des cellules conformément à un autre mode de réalisation de l'invention;
- la figure 8 est une vue schématique en perspective montrant le déploiement d'une structure fibreuse sur un outillage de conformation;
- la figure 9 est une vue en perspective d'une structure alvéolaire courbée utilisée pour la réalisation d'un panneau d'atténuation acoustique conformément à un mode de réalisation de l'invention;
- la figure 10 est une vue schématique montrant deux structures fibreuses destinées à former des peaux d'un panneau d'atténuation acoustique conformément à un mode de réalisation de l'invention;
- la figure 11 est une vue schématique en perspective éclatée montrant l'assemblage des peaux au stade imprégné avec une structure alvéolaire au stade polymérisé.

### Description détaillée d'un mode de réalisation

Le panneau d'atténuation acoustique selon l'invention, ou plus précisément les éléments qui le composent, sont réalisés en matériau composite thermostructural, c'est-à-dire un matériau composite ayant des bonnes propriétés mécaniques et une capacité à conserver ces propriétés à température élevée. Des matériaux composites thermostructuraux typiques sont les matériaux composites carbone/carbone (C/C) formés d'un renfort en fibres de carbone densifié par une matrice en carbone et les matériaux composites à matrice céramique (CMC) formés d'un renfort en fibres réfractaires (carbone ou céramique) densifié par une matrice au moins partiellement céramique. Des exemples de CMC sont les composites C/SiC (renfort en fibres de carbone et matrice en carbure de silicium), les composites C/C-SiC (renfort en fibres de carbone et matrice comprenant une phase carbone, généralement au plus près des fibres, et une phase carbure de silicium), les composites SiC/SiC (fibres de renfort et matrice en carbure de silicium) et les composites oxyde/oxyde (fibres de renfort et matrice en alumine). Une couche d'interphase peut être interposée entre les fibres de renfort et la matrice pour améliorer la tenue mécanique du matériau.

La fabrication de pièces en matériau composite thermostructural est bien connue.

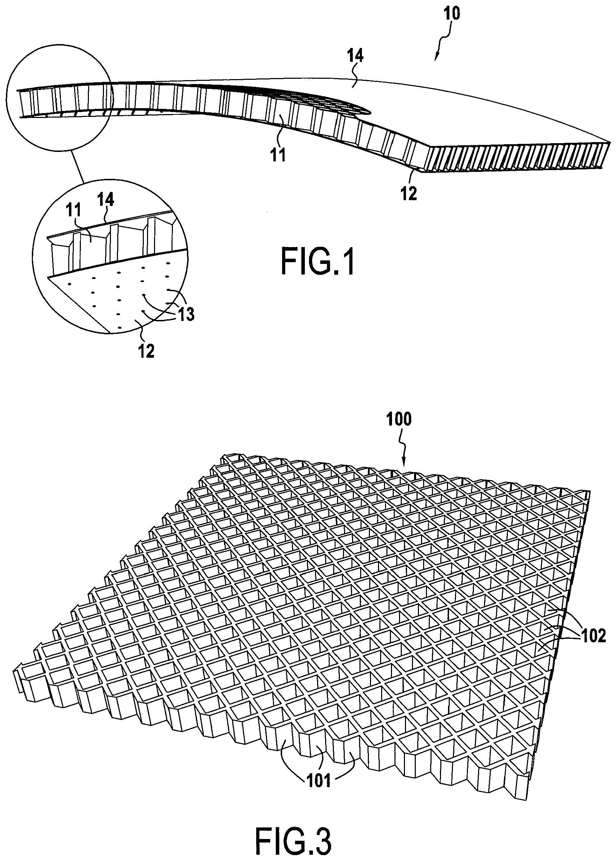

La figure 1 représente un panneau d'atténuation acoustique 10 comprenant une structure alvéolaire 11 disposée entre une peau acoustique 12 comportant des perforations 13 et une peau structurale 14, tous ces éléments étant réalisés, dans l'exemple décrit ici, en matériau composite CMC.

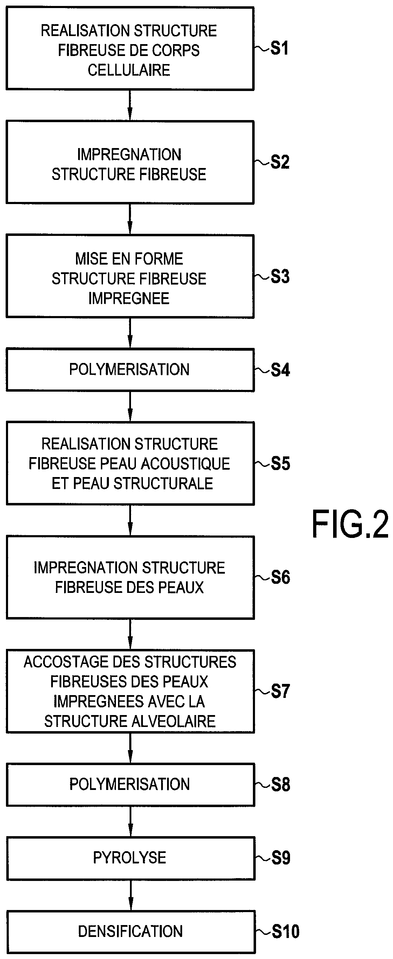

Selon un mode de mise en oeuvre du procédé de l'invention décrit sur la figure 2, la fabrication d'un panneau d'atténuation acoustique selon l'invention débute par la réalisation d'une structure alvéolaire ou corps cellulaire qui comprend l'élaboration d'une structure fibreuse en fibres réfractaires, en particulier en fibres de carbone ou céramique, définissant une structure alvéolaire (étape S1) comme la structure fibreuse 100 représentée sur la figure 3 qui présente des parois verticales 101 délimitant des alvéoles ou cellules 102 de forme hexagonales.

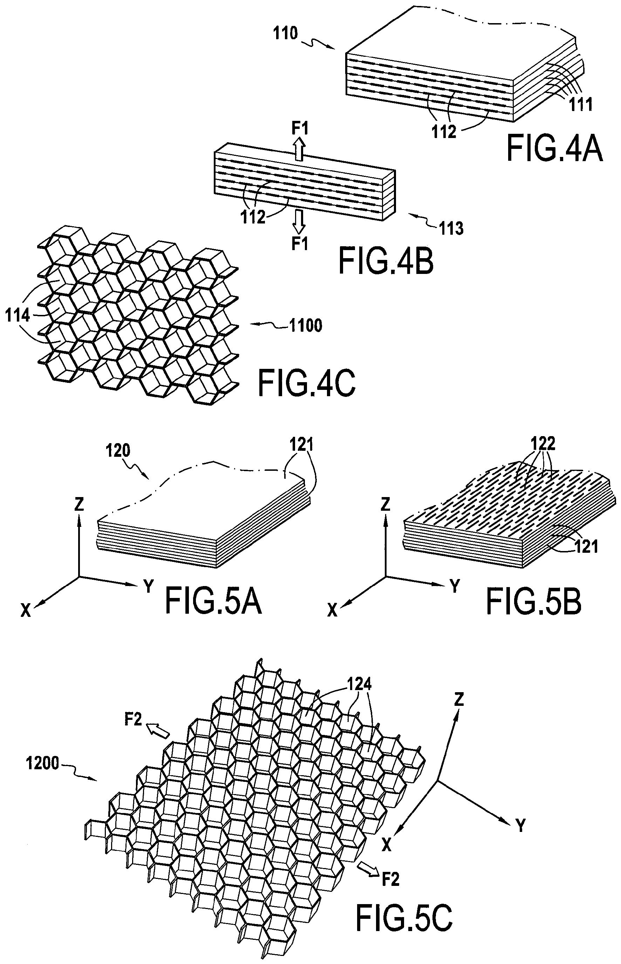

La structure fibreuse destinée à former le renfort de la structure alvéolaire peut être réalisée de différentes manières comme notamment celles décrites dans le document US 5 415 715. Elle peut notamment être réalisée, comme illustré sur les figures 4A à 4C, en empilant et en liant en quinconce des strates de tissu 111, par exemple en fibre de carbure de silicium (SiC) de manière à former une texture 110. La liaison entre les strates 111 est réalisée le long de bandes 112 parallèles, les bandes 112 situées sur une face d'une strate étant décalées par rapport à celles situées sur l'autre face (figure 4A). Les bandes 112 de liaison entre les strates 111 peuvent être réalisées notamment par collage ou couture. L'empilement des strates est découpé en tronçons 113, perpendiculairement aux bandes de colle (figure 4B). Chaque tronçon est ensuite étiré en direction normale aux faces des strates (flèches f1 de la figure 4B) pour donner, par déformation, des structures alvéolaires 1100 avec ici des cellules hexagonales 114 (figure 4C).

Selon une variante de réalisation illustrée sur les figures 5A à 5C, des strates bidimensionnelles 121, par exemple en fibres SiC, sont superposées et aiguilletées afin de former une texture 120 (figure 5A). Les strates 121 sont des couches par exemple de tissu ou de complexe formé de tissu et voile de fibres, le voile de fibres apportant des fibres pouvant être aisément prélevées par les aiguilles, lors de l'aiguilletage, pour être implantées à travers les strates. Comme le montre la figure 5B, des découpes 122 en forme de fentes sont réalisées en quinconce dans la texture 120, par exemple au jet d'eau ou laser, leurs dimensions et localisations définissant les dimensions et formes des alvéoles. Après réalisation des découpes, la texture 120 est étirée en direction perpendiculaire aux plans des découpes pour donner, par déformation, une structure alvéolaire 1200 avec ici des cellules hexagonales 124 (flèches f2 de la figure 5C).

Selon encore une autre variante de réalisation, la structure fibreuse destinée à former le renfort de la structure alvéolaire peut être réalisée en disposant des bandes de tissus dans le plan des parois des alvéoles et en liant ces bandes au niveau des jonctions entre les alvéoles.

Selon toujours une autre variante de réalisation, on réalise une structure fibreuse déployable par tissage tridimensionnel ou multicouche

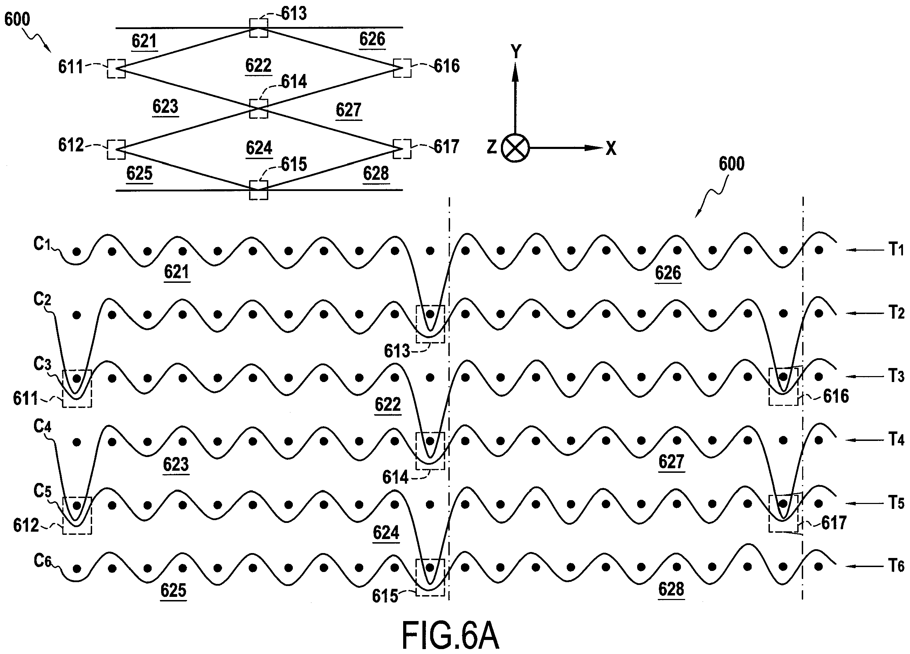

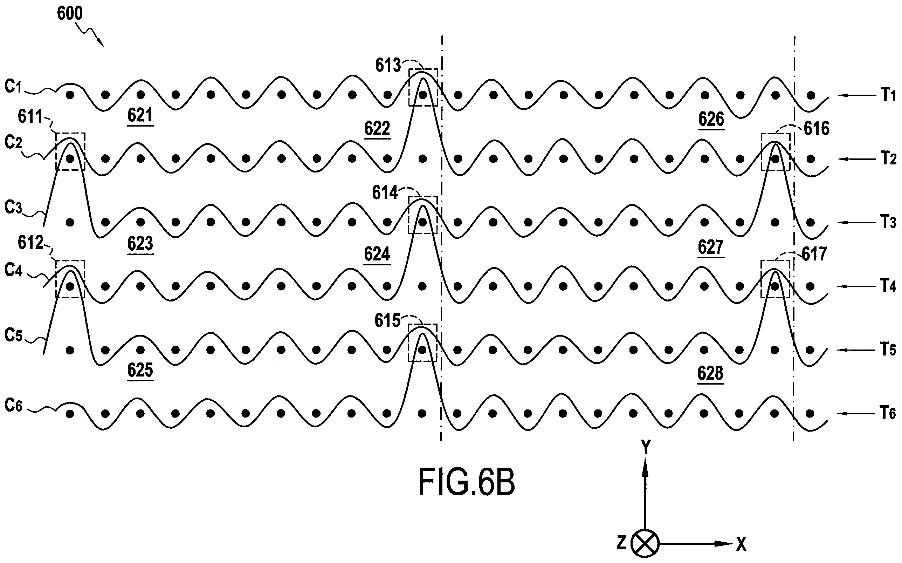

Un mode de tissage multicouche d'une structure fibreuse déployable 600 est montré schématiquement par les figures 6A et 6B qui sont respectivement des vues agrandies de deux plans successifs d'une armure de tissage de type multi-toile, les fils de trame étant visibles en coupe. Dans cet exemple, la structure 600 comprend 6 couches de fils de trame T1 à T6 s'étendant dans une direction Z correspondant à l'axe des cellules de la structure alvéolaire. Sur les figures 6A et 6B, chaque couche de fils de trame est liée par des fils de chaîne C1 à C6 appartenant chacun respectivement à une couche de fils de chaîne. L'épaisseur de la structure fibreuse et, par conséquent la hauteur des cellules formées ultérieurement par déploiement de la structure 600, s'étend suivant la direction Z et est déterminée par la longueur des fils de trame tissés par les fils de chaîne, c'est-à-dire le nombre de répétition des plans des figures 6A et 6B. La longueur et la largeur de la structure 600 sont définies respectivement par le nombre de fils de trame par couche (direction X) et par le nombre de couches de fils de trame tissées (direction Y).

Par souci de simplification, 6 couches de fils de chaîne et 6 couches de fils de trame sont représentés ici. Bien entendu, suivant les dimensions (largeur et épaisseur) de la structure fibreuse que l'on souhaite obtenir, cette dernière pourra être réalisée avec un nombre de couches de fils de chaîne et de trame plus importants, en particulier pour augmenter le nombre de cellules dans la direction Y de la structure fibreuse. Toujours par souci de concision, seuls 22 fils de trame sont représentés ici de manière à montrer la réalisation de deux cellules adjacentes en forme de losange comme représentées sur la figure 6A. Bien entendu, le nombre de fils de trame par couche peut être plus important afin d'augmenter le nombre de cellules dans la direction X de la structure fibreuse.

Des portions de liaison 611 à 617 sont réalisées entre les fils de deux couches de fils de trame adjacentes. Ces portions de liaison délimitent des zones de déliaisons 621 à 628 qui formeront chacune tout ou partie d'une cellule une fois la structure fibreuse déployée.

La structure fibreuse 600 décrite ci-avant est tissée avec ses fils de trame parallèles à l'axe des cellules (0°) tandis que les fils de chaîne sont perpendiculaires à l'axe des cellules (90°). Toutefois, les fils de trame et de chaîne peuvent être orientés différemment par rapport à l'axe des cellules. En particulier, les structures fibreuses peuvent être tissées de manière à ce que les fils de trame et de chaîne soient orientées à 45° par rapport à l'axe des cellules, ce qui permet une déformation plus importante de la structure fibreuse lors de son déploiement favorisant ainsi une bonne mise en forme sur une surface gauche.

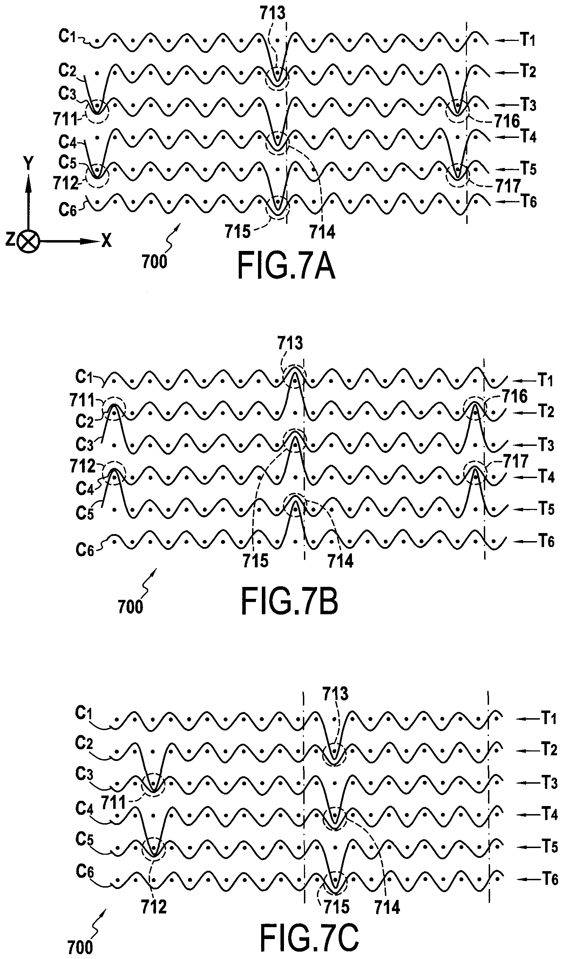

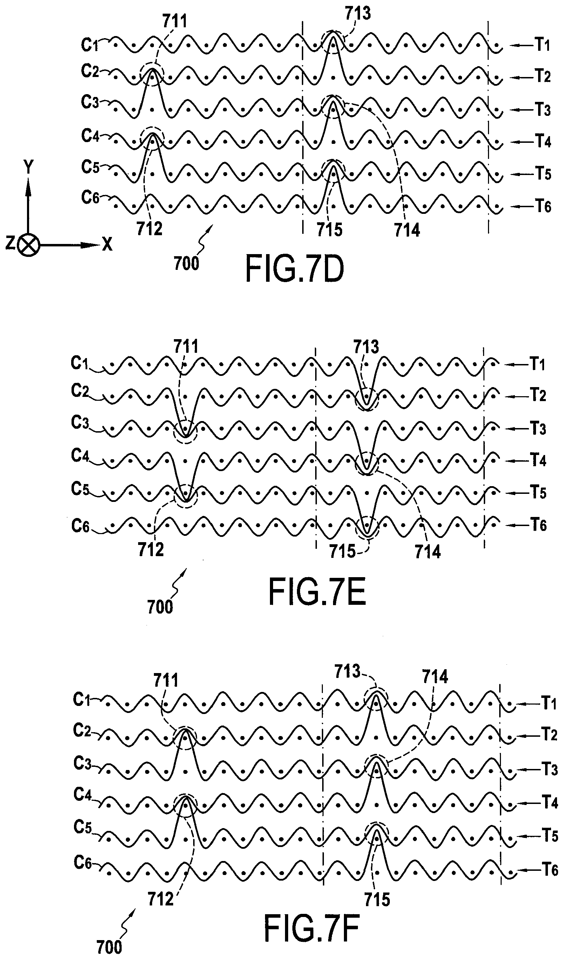

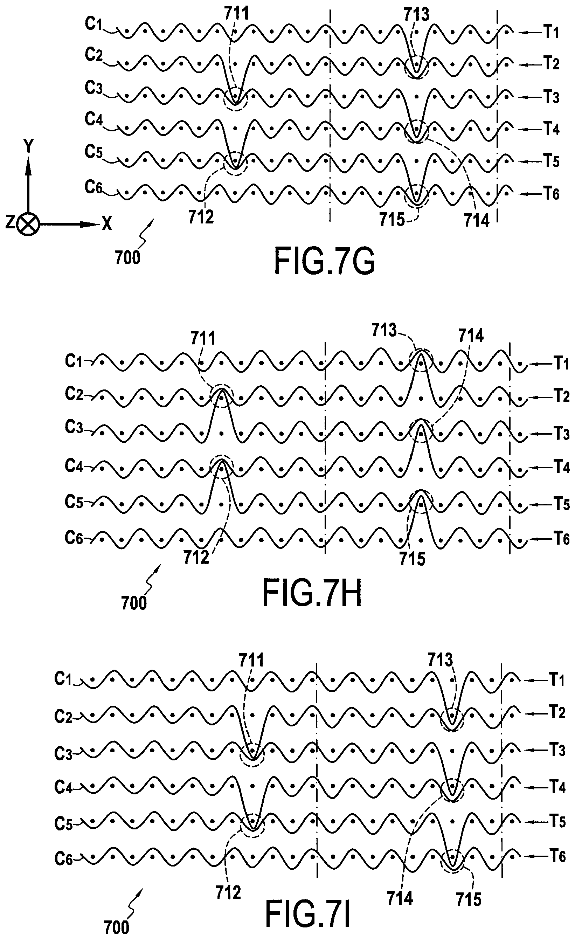

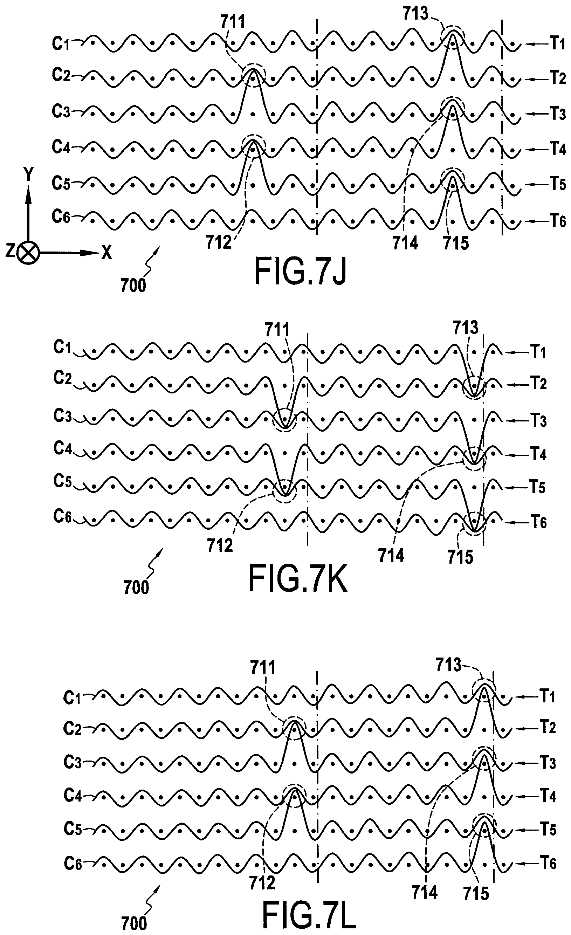

Les figures 7A à 7L montrent des plans d'armure permettant de réaliser une structure fibreuse 700 du même type que la structure 600 déjà décrite, c'est-à-dire une structure fibreuse permettant de former des cellules en losange, mais dont les fils de trame et de chaîne sont orientés à 45° par rapport à l'axe de chaque cellule. Le tissage de la structure fibreuse 700 diffère de celui de la structure 600 en ce qu'on décale les portions de liaison de deux fils de trame tous les deux plans, ici de deux fils de trame, comme illustré pour les portions de liaison 711 à 717 entre les figures 7A et 7C, 7B et 7D, 7C et 7E, etc..

La structure fibreuse destinée à former le renfort de la structure alvéolaire selon l'invention peut être également réalisée par tissage multicouche ou 3D de type interlock. Par "tissage interlock", on entend ici une armure de tissage multicouche ou 3D dont chaque couche de chaîne lie plusieurs couches de trame avec tous les fils de la même colonne de chaîne ayant le même mouvement dans le plan de l'armure avec croisement de fils de chaîne dans les couches de trame.

Une fois réalisée, la structure fibreuse 100 est imprégnée avec une composition liquide contenant un précurseur organique d'un matériau céramique (étape S2). A cet effet, la texture fibreuse est immergée dans un bain contenant la résine et habituellement un solvant de celle-ci. Après égouttage, un pré-poussage (pré-polymérisation) est réalisé en étuve. Le séchage doit être réalisé à une température modérée pour préserver une déformabilité suffisante de la texture fibreuse.

D'autres techniques connues d'imprégnation peuvent être utilisées, telles que passage de la texture fibreuse dans une imprégnatrice en continu, imprégnation par infusion, ou encore imprégnation par RTM ("Resin Transfer Moulding").

Le précurseur organique se présente habituellement sous forme d'un polymère, tel qu'une résine, éventuellement dilué dans un solvant. A titre d'exemple, des précurseurs liquides de céramique, notamment de SiC, peuvent être des résines de type polycarbosilane (PCS), polysiloxane (PSX), polytitanocarbosilane (PTCS), ou polysilazane (PSZ) tandis qu'un précurseur liquide de carbone peut être une résine de type phénolique.

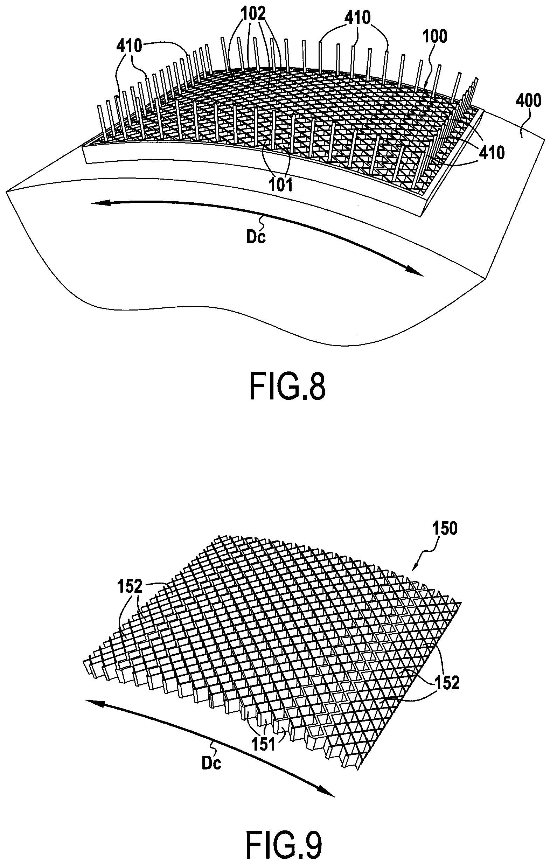

Le structure fibreuse 100 imprégnée est ensuite déployée et mise en forme par conformation sur un outillage de maintien 400 qui présente une forme courbée suivant une direction Dc correspondant à la forme finale du corps cellulaire à fabriquer, laquelle est elle-même proche de la forme de la pièce sur laquelle le panneau d'atténuation acoustique est destiné à être monté (étape S3, figure 8). Dans l'exemple décrit ici, l'outillage de maintien 400 présente une forme cylindrique et comprend des pions 410 pour maintenir en position la structure sur l'outillage 400.

Après le déploiement et la mise en forme de la structure fibreuse 100 sur l'outillage 400, la résine d'imprégnation de la structure fibreuse 100 est polymérisée afin de lui conférer une certaine tenue mécanique lui permettant de conserver sa mise en forme lors des manipulations (étape S4). On obtient alors une structure alvéolaire 150 présentant une forme courbée et comportant une pluralité de cellules 152 délimitées par des parois 151 (figure 9).

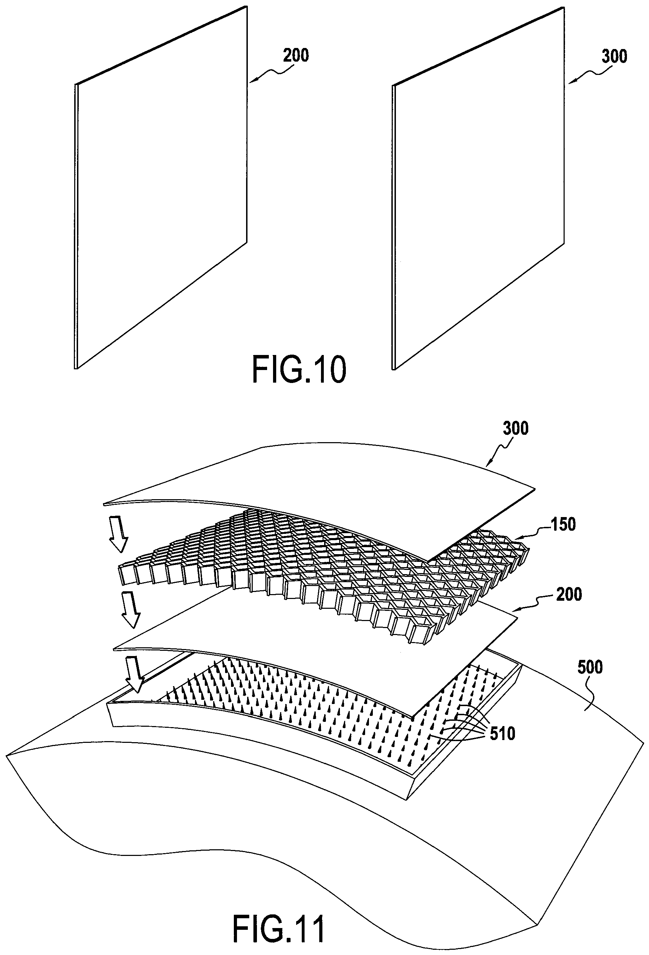

On réalise ensuite deux structures fibreuses planes destinées à former des première et deuxième peaux, ou peaux interne et externe, du panneau acoustique (étape S5). A cet effet, on élabore deux structures fibreuses 200 et 300 comme représentées sur la figure 10. Les structures fibreuses des peaux peuvent être obtenues à partir de textures fibreuses en fibres réfractaires (carbone ou céramique). Les textures fibreuses utilisées peuvent être de diverses natures et formes telles que notamment:
- tissu bidimensionnel (2D),
- tissu tridimensionnel (3D) obtenu par tissage 3D ou multicouches tel que notamment décrit dans le document WO 2010/061140,
- tricot,
- feutre,
- nappe unidirectionnelle (UD) de fils ou câbles ou nappes multidirectionnelle (nD) obtenue par superposition de plusieurs nappes UD dans des directions différentes et liaison des nappes UD entre elles par exemple par couture, par agent de liaison chimique ou par aiguilletage.

On peut aussi utiliser une structure fibreuse formée de plusieurs couches superposées de tissu, tresse, tricot, feutre, nappes, câbles ou autres, lesquelles couches sont liées entre elles par exemple par couture, par implantation de fils ou d'éléments rigides ou par aiguilletage.

Une fois réalisées, les structures fibreuses 200 et 300 sont imprégnées avec une composition liquide contenant au moins une résine organique précurseur d'un matériau céramique suivant une des techniques d'imprégnation décrites ci-avant (étape S6).

L'étape suivante consiste à accoster deux peaux au corps cellulaire. Comme décrit ci-après, chaque peau peut être accostée au corps cellulaire au stade imprégné ou au stade polymérisé.

Selon un premier mode de réalisation de l'invention, les structures fibreuses 200 et 300 sont accostées à la structure alvéolaire 150 au stade imprégné, c'est-à-dire avant la polymérisation de la résine précurseur organique (étape S7). A cet effet, comme illustrée sur la figure 11, la structure fibreuse 200 est placée sur un outillage 500 présentant comme l'outillage 400 une forme courbée correspondant à celle du panneau acoustique à fabriquer ainsi que celle de la pièce sur laquelle il est destiné à être monté. L'outillage 500 comprend en outre sur sa surface une pluralité d'aiguilles 510 destinées à former des perforations dans la structure fibreuse 200. La structure alvéolaire 150 est alors placée sur la structure fibreuse 200 imprégnée. La structure fibreuse 300 imprégnée est ensuite placée sur la partie supérieure du corps cellulaire qui, grâce à sa consolidation, forme un support de conformation pour la structure 300. La résine d'imprégnation des structures fibreuses 200 et 300 est polymérisée de manière à conférer à ces dernières une tenue suffisante pour qu'elles conservent leur mise en forme lors des opérations ultérieures (étape S8). On obtient ainsi deux peaux et entre lesquelles est interposé la structure alvéolaire. Afin d'augmenter la liaison entre les peaux, d'une part, et le corps cellulaire, d'autre part, une colle peut être déposée entre les parties jointives de ces éléments. La colle utilisée peut être constituée par exemple d'un mélange d'une résine précéramique (40% en masse) et d'une charge de carbure de silicium de granulométrie d'environ 9 µm (60% en masse). L'application de la colle peut être réalisée par trempage de la structure alvéolaire dans un bain de colle ou par application de celle-ci par voie barbotine sur la structure alvéolaire. Toute autre colle à base de précurseur de céramique et qui présente une tenue haute température peut être utilisée.

L'ensemble est alors soumis à un traitement de pyrolyse sous gaz neutre de manière à transformer la matrice polymère en une céramique (étape S9).

A ce stade, la structure alvéolaire et les peaux présentent encore une porosité qui est réduite à un niveau déterminé par la technique bien connue d'infiltration chimique en voie gazeuse (CVI) de carbure de silicium. A cet effet, l'assemblage constitué de la structure alvéolaire et des peaux est placé dans un four dans lequel est admise une phase gazeuse réactionnelle. La pression et la température régnant dans le four et la composition de la phase gazeuse sont choisies de manière à permettre la diffusion de la phase gazeuse au sein de la porosité des pièces pour y former une matrice par dépôt d'un matériau solide résultant d'une décomposition d'un constituant de la phase gazeuse ou d'une réaction entre plusieurs constituants. A titre d'exemple, des précurseurs gazeux de céramique, notamment de SiC, peut-être du méthyltrichlorosilane (MTS) donnant du SiC par décomposition du MTS (éventuellement en présence d'hydrogène).

Cette co-densification des pièces du panneau d'atténuation acoustique assure la liaison finale entre ces pièces.

On obtient alors le panneau d'atténuation acoustique 10 de la figure 1 présentant une forme courbée et comprenant une structure alvéolaire 11 disposée entre une peau acoustique 12 comportant des perforations 13 et une peau structurale 14, tous ces éléments étant en matériau composite CMC.

L'accostage des peaux à la structure alvéolaire peut être réalisé de différentes manières. Dans l'exemple décrit ci-avant, les peaux sont toutes les deux accostées à la structure alvéolaire au stade imprégné, c'est-à-dire avant polymérisation de la résine d'imprégnation des structures fibreuses destinées à former les peaux.

Selon une variante de mise en oeuvre du procédé de l'invention, une première peau, par exemple la peau acoustique, est accostée à la partie inférieure de la structure alvéolaire au stade imprégné puis est soumise à un traitement de polymérisation. La deuxième peau, par exemple ici la peau structurale, est ensuite accostée à la partie supérieure de la structure alvéolaire au stade imprégné avant d'être soumise à un traitement de polymérisation. Une colle du type déjà décrit ci-avant peut être disposée entre les parties jointives de la structure alvéolaire et des peaux. En outre, une fois la peau acoustique accostée et polymérisée, des performations peuvent être réalisées dans celle-ci, par exemple par perçage mécanique, laser ou au jet d'eau, avant l'accostage de la deuxième peau structurale. Cela permet d'usiner les perforations dans la peau acoustique sans risque d'endommager la peau structurale.

Selon une autre variante de mise en oeuvre du procédé, une des deux peaux ou les deux peaux sont soumises à un traitement de polymérisation avant leur accostage à la structure alvéolaire. Dans ce cas, la ou les deux structures fibreuses imprégnées destinées à former la ou les peaux sont soumises à un traitement de polymérisation tout en étant maintenues sur un outillage de conformation présentant une forme courbée correspondant à celle de la structure alvéolaire. La ou les peaux ainsi consolidées en forme sont ensuite accostées à la structure alvéolaire avec interposition d'une colle du type déjà décrit ci-avant entre les parties jointives de la structure alvéolaire et les peaux.

La peau acoustique, c'est-à-dire la peau comportant des perforations, peut être placée du côté inférieur ou du côté supérieur de la structure alvéolaire en fonction des besoins d'atténuation acoustique du panneau. Les perforations dans la peau acoustique peuvent être réalisées à différents stades et de différentes façons. Lorsque les perforations sont réalisées dans la structure fibreuse au stade imprégnée, la structure est soumise à un traitement de polymérisation alors qu'elle est placée sur un outillage comportant une pluralité d'aiguilles permettant de ménager des ouvertures dans la structure qui forment des perforations après polymérisation comme décrit ci-avant (figure 11).

Les perforations peuvent être encore réalisées dans la peau acoustique après avoir soumise celle-ci à une polymérisation, une pyrolyse ou une densification par voie gazeuse. Dans ce cas, les perforations sont réalisées par perçage mécanique, laser, jet d'eau sous pression, etc.

Le panneau d'atténuation acoustique de l'invention peut être utilisé d'une manière générale dans tout conduit d'échappement d'une turbine à gaz. Il peut en particulier équiper différentes parties d'une tuyère d'un moteur aéronautique tel que le conduit d'échappement d'un turboréacteur. Il peut également être utilisé sur la surface interne d'une nacelle de moteur aéronautique afin d'atténuer les ondes sonores se propageant depuis le corps du moteur. Le panneau d'atténuation acoustique de l'invention peut encore être avantageusement utilisé dans des inverseurs de poussée de moteurs aéronautique notamment au niveau des écopes de tels inverseurs.

La forme et les dimensions du panneau sont définies en fonction de la pièce sur laquelle le panneau est monté et de la zone sur laquelle on souhaite réaliser l'atténuation acoustique.

La réalisation du panneau d'atténuation acoustique en matériau composite à matrice céramique permet d'alléger la masse de la pièce tout en assurant une tenue structurale à haute température (supérieure à 700°C). Dans le cas d'un système d'échappement par exemple, l'utilisation de panneaux d'atténuation acoustique en CMC dans le cône d'échappement et dans la tuyère permet d'intégrer la fonction d'atténuation acoustique dans les arrière-corps de moteurs aéronautiques sans pénaliser la masse du système d'éjection.

## Revendications

1. Procédé de fabrication d'un panneau d'atténuation acoustique de forme courbée (10) comprenant les étapes suivantes :
- imprégnation d'une structure fibreuse (100) définissant une structure alvéolaire (150) avec une résine précurseur de céramique,
- polymérisation de la résine précurseur de céramique avec maintien de la structure fibreuse (100) sur un outillage (400) présentant une forme courbée correspondant à la forme finale de la structure alvéolaire (150),
- accostage de la structure alvéolaire (150) avec des première et deuxième peaux de manière à fermer les cellules de ladite structure alvéolaire, chaque peau étant formée d'une structure fibreuse (200 ; 300) imprégnée avec une résine précurseur de céramique, chaque peau étant accostée à ladite structure alvéolaire avant ou après polymérisation de la résine desdites peaux, et avant transformation de la résine de la structure alvéolaire en céramique par pyrolyse,
- pyrolyse de l'assemblage constitué par la structure alvéolaire et les première et deuxième peaux,
- densification dudit assemblage par infiltration chimique en voie gazeuse.

2. Procédé selon la revendication 1, **caractérisé en ce qu'**au moins une des deux peaux est accostée à la structure alvéolaire (150) avant polymérisation de la résine d'imprégnation de la peau et **en ce que** le procédé comprend une étape de polymérisation de la résine de ladite peau après l'étape d'accostage et avant l'étape de pyrolyse.

3. Procédé selon la revendication 2, **caractérisé en ce qu'**une des deux peaux est placée sur un outillage (500) comportant des aiguilles (510) traversant ladite peau, la structure alvéolaire (150) étant accostée avec ladite peau placée sur l'outillage de manière à réaliser des perforations dans ladite peau.

4. Procédé selon l'une des revendications 1 à 3, **caractérisé en ce que** la résine d'au moins une des deux peaux est polymérisée avant son accostage avec la structure alvéolaire (150), ladite peau étant maintenue pendant la polymérisation sur un outillage (400) présentant une forme courbée similaire à la forme courbée de la structure alvéolaire et **en ce qu'**une colle comprenant au moins une résine précurseur de céramique est déposée sur les parties de la structure alvéolaire destinées à être en contact avec la peau.

5. Procédé selon la revendication 4, **caractérisé en ce que** la colle comprend en outre une charge solide constituée d'une poudre d'un matériau réfractaire.

6. Procédé selon l'une quelconque des revendications 1 à 5, **caractérisé en ce que** la première peau est accostée à la structure alvéolaire (150) et **en ce que** le procédé comprend, avant l'accostage de la deuxième peau à la structure alvéolaire, une étape de perçage de multiperforations dans la première peau, la deuxième peau étant accostée à la structure alvéolaire après ladite étape de perçage.

7. Procédé selon l'une quelconque des revendications 1 à 6, **caractérisé en ce qu'**il comprend la réalisation d'une structure fibreuse déployable (100) définissant une structure alvéolaire (150).

8. Procédé selon la revendication 7, **caractérisé en ce que** la structure fibreuse déployable (600) est réalisée par tissage tridimensionnel ou tissage multicouche.

9. Procédé selon l'une quelconque des revendications 1 à 8, **caractérisé en ce que** les structures fibreuses (100, 200, 300) du corps cellulaire et des peaux sont réalisées à partir de fibres de carbure de silicium.

10. Procédé selon l'une quelconque des revendications 1 à 9, **caractérisé en ce que** la résine d'imprégnation de la structure alvéolaire et des peaux est une résine précurseur de carbure de silicium et **en ce que** l'étape de densification comprend l'infiltration chimique en voie gazeuse de carbure de silicium.

## Patentansprüche

1. Verfahren zur Herstellung einer kurvenförmigen, schalldämpfenden Platte (10), umfassend die folgenden Schritte:
- Imprägnieren einer Faserstruktur (100), die eine Wabenstruktur (150) mit einem keramischen Vorläuferharz definiert,
- Polymerisieren des keramischen Vorläuferharzes unter Beibehaltung der Faserstruktur (100) auf einem Werkzeug (400) mit einer der Endform der Wabenstruktur (150) entsprechenden Kurvenform,
- Befestigen der Wabenstruktur (150) an einer ersten und einer zweiten Haut, sodass die Zellen der Wabenstruktur verschlossen werden, wobei jede Haut aus einer Faserstruktur (200; 300) gebildet ist, die mit einem keramischen Vorläuferharz imprägniert ist, wobei jede Haut vor oder nach der Polymerisation des Harzes der Haut und vor der Umwandlung des Harzes der Wabenstruktur in Keramik durch Pyrolyse an der Wabenstruktur befestigt wird,
- Pyrolysieren der Anordnung aus der Wabenstruktur und der ersten und zweiten Haut,
- Verdichten dieser Anordnung durch chemische Gasphaseninfiltration.

2. Verfahren gemäß Anspruch 1, **dadurch gekennzeichnet, dass** mindestens eine der beiden Häute vor der Polymerisation des Hautimprägnierharzes an der Wabenstruktur (150) befestigt wird und dass das Verfahren einen Schritt des Polymerisierens des Hautharzes nach dem Schritt des Befestigens und vor dem Schritt des Pyrolysierens umfasst.

3. Verfahren gemäß Anspruch 2, **dadurch gekennzeichnet, dass** eine der beiden Häute auf einem Werkzeug (500) angeordnet wird, das Nadeln (510) umfasst, die die Haut durchqueren, wobei die Wabenstruktur (150) an der auf dem Werkzeug angeordneten Haut befestigt wird, sodass Perforationen in der Haut erzeugt werden.

4. Verfahren gemäß einem der Ansprüche 1 bis 3, **dadurch gekennzeichnet, dass** das Harz mindestens einer der beiden Häute vor dem Befestigen an der Wabenstruktur (150) polymerisiert wird, wobei die Haut während der Polymerisation auf einem Werkzeug (400) mit einer der Kurvenform der Wabenstruktur ähnlichen Kurvenform gehalten wird, und dass ein Klebstoff mit mindestens einem keramischen Vorläuferharz auf die Teile der Wabenstruktur aufgebracht wird, die dazu bestimmt sind, mit der Haut in Kontakt zu kommen.

5. Verfahren gemäß Anspruch 4, **dadurch gekennzeichnet, dass** der Klebstoff weiterhin einen festen Füllstoff umfasst, der aus einem Pulver aus einem feuerfesten Material besteht.

6. Verfahren gemäß einem der Ansprüche 1 bis 5, **dadurch gekennzeichnet, dass** die erste Haut an der Wabenstruktur (150) befestigt wird und dass das Verfahren vor dem Befestigen der zweiten Haut an der Wabenstruktur einen Schritt des Durchstechens von Mehrfachperforationen in der ersten Haut umfasst, wobei die zweite Haut nach dem Schritt des Durchstechens an der Wabenstruktur befestigt wird.

7. Verfahren gemäß einem der Ansprüche 1 bis 6, **dadurch gekennzeichnet, dass** es das Herstellen einer entfaltbaren Faserstruktur (100) umfasst, die eine Wabenstruktur (150) definiert.

8. Verfahren gemäß Anspruch 7, **dadurch gekennzeichnet, dass** die entfaltbare Faserstruktur (600) durch dreidimensionales Weben oder mehrlagiges Weben hergestellt wird.

9. Verfahren gemäß einem der Ansprüche 1 bis 8, **dadurch gekennzeichnet, dass** die Faserstrukturen (100, 200, 300) des Zellkörpers und die Häute aus Siliziumkarbidfasern bestehen.

10. Verfahren gemäß einem der Ansprüche 1 bis 9, **dadurch gekennzeichnet, dass** es sich bei dem Imprägnierharz der Wabenstruktur und der Häute um ein Siliziumkarbid-Vorläuferharz handelt und dass der Schritt des Verdichtens die chemische Gasphaseninfiltration von Siliziumkarbid umfasst.

## Claims

1. A method of fabricating a sound attenuation panel of curved shape (10), the method comprises the following steps:
• impregnating a fiber structure (100) defining a cellular structure (150) with a ceramic precursor resin;
• polymerizing the ceramic precursor resin while holding the fiber structure (100) on tooling (400) presenting a curved shape corresponding to the final shape of the cellular structure (150);
• docking the cellular structure (150) with first and second skins so as to close the cells of said cellular structure, each skin being formed by a fiber structure (200; 300) impregnated with a ceramic precursor resin, each skin being docked to said cellular structure before or after polymerizing the resin of said skins, and before transformation of the resin of the cellular structure into ceramic by pyrolysis;
• pyrolyzing the assembly constituted by the cellular structure and the first and second skins; and
• densifying said assembly by chemical vapor infiltration.

2. A method according to claim 1, **characterized in that** at least one of the two skins is docked to the cellular structure (150) prior to polymerizing the impregnation resin of the skin, and **in that** the method includes a step of polymerizing the resin of said skin after the docking step and before the pyrolysis step.

3. A method according to claim 2, **characterized in that** one of the two skins is placed on tooling (500) having needles (510) passing through the skin, the cellular structure (150) being docked with said skin placed on the tooling so as to make perforations in said skin.

4. A method according to any one of claims 1 to 3, **characterized in that** the resin of at least one of the two skins is polymerized before docking with the cellular structure (150), said skin being held during polymerization on tooling (400) that presents a curved shape similar to the curved shape of the cellular structure, and **in that** an adhesive including at least a ceramic precursor resin is placed on the portions of the cellular structure that are to come into contact with the skin.

5. A method according to claim 4, **characterized in that** the adhesive further includes a solid filler constituted by a powder of a refractory material.

6. A method according to any one of claims 1 to 5, **characterized in that** the first skin is docked to the cellular structure (150), and **in that** the method includes, prior to docking the second skin to the cellular structure, a step of making multiple perforations in the first skin, the second skin being docked to the cellular structure after said step of making multiple perforations.

7. A method according to any one of claims 1 to 6, **characterized in that** it includes making an expandable fiber structure (100) defining a cellular structure (150).

8. A method according to claim 7, **characterized in that** the expandable fiber structure (600) is made by three-dimensional weaving or by multilayer weaving.

9. A method according to any one of claims 1 to 8, **characterized in that** the fiber structures (100, 200, 300) of the cellular body and of the skins are made from silicon carbide fibers.

10. A method according to any one of claims 1 to 9, **characterized in that** the impregnation resin of the cellular structure and of the skins is a silicon carbide precursor resin, and **in that** the densification step comprises chemical vapor infiltration of silicon carbide.
